# EUROPEAN PATENT APPLICATION

(11) **EP 3 010 021 A1**
(43) Date of publication of application: **20.04.2016**
(21) Application number: 15183117.9
(22) Date of filing: 31.08.2015
(51) Int. Cl.: G11C 11/412

(54) **ASYMMETRIC 6T SRAM CELL WITH WRITE INVERTER AND READ INVERTER**

(30) Priority: 16.10.2014 TW 103135848; 18.02.2015 US 201514624847
(71) Applicant: Hsiao, Chih-Cheng, Taichung City 403 (TW)
(72) Inventor: Hsiao, Chih-Cheng, Taichung City 403 (TW)
(74) Representative: Becker Kurig Straus

(57) **Abstract**

A 6T SRAM cell includes a write inverter (2) which includes a write pull-up transistor (21) and a write pull-down transistor (22), a read inverter (3) which includes a read pull-up transistor (31) and a read pull-down transistor (32), a write access transistor (4), and a read access transistor (5). To-be-written data is written into the 6T SRAM cell via the write access transistor (4) in a one-sided write operation, and to-be-read data is read via the read access transistor (5) in a one-sided read operation. Equivalent resistance of the read pull-up transistor (31) is smaller than that of the read access transistor (5), and equivalent resistance of the read pull-down transistor (32) is smaller than that of the read access transistor (5).

## Description

### Field of the Invention

The invention relates to a 6T SRAM cell capable of reducing electricity consumption.

### Background of the Invention

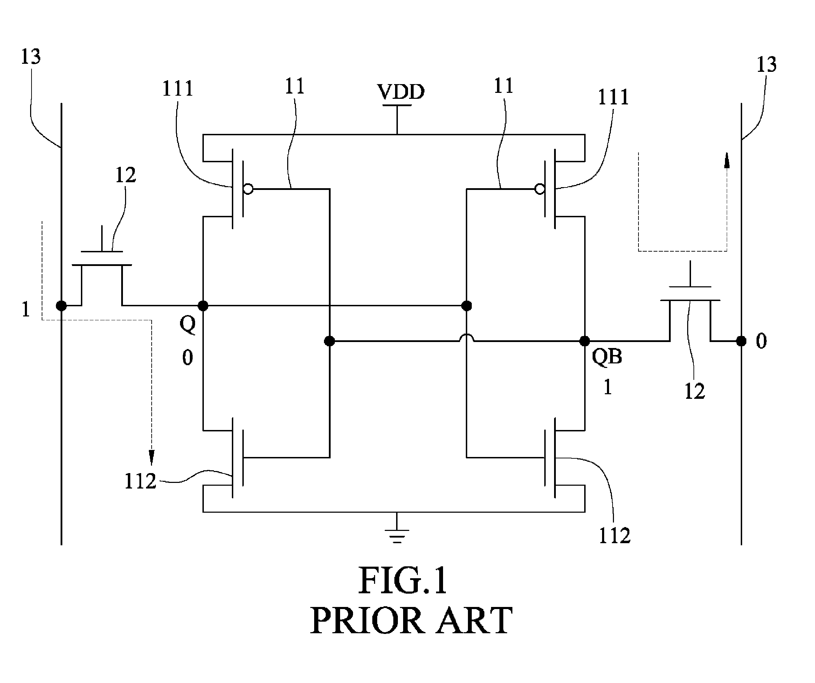

Referring to Figure 1, a conventional 6T SRAM (six-transistor static random-access memory) cell includes two cross-coupled inverters 11, and two access transistors 12 as disclosed in "Nanometer Variation-Tolerant SRAM: Circuit and Statistical Design for Yield, Chapter 2 by Mohamed Abu-Rahma, and Mohab Anis".

Each of the inverters 11 includes a pull-up transistor 111 and a pull-down transistor 112 which are connected in series between a supply voltage source (VDD) and a complementary voltage source (GND). Each of the access transistors 12 is connected between a respective one of the inverters 11 and a bit line 13.

For achieving favorable read margin, equivalent resistance of each pull-down transistor 112 is required to be smaller than that of each access transistor 12, so that data stored at the junction of one of the pull-up transistors 111 and the corresponding one of the pull-down transistors 112 may not be adversely influenced (Chapter 2.6.1.2 Read Stability Failure).

On the other hand, for achieving favorable write margin, equivalent resistance of each access transistor 12 is required to be smaller than that of each pull-up transistor 111, so that a better transition effect may be obtained (Chapter 2.6.1.3 Write Stability Failure).

Since two-sided write operation is usually adopted in the conventional technical field, higher electricity consumption may be caused during write operation. Specifically, when an output terminal (Q) of the inverter 11 on the left-hand side is at a low voltage level, and when an output terminal (QB) of the inverter 11 on the right-hand side is at a high voltage level, if data held by the bit line 13 on the left-hand side is at a high voltage level and data held by the bit line 13 on the right-hand side is at a low voltage level, after the access transistors 12 have been turned on and before transition of the inverters 11 is completed, the bit line 13, the access transistor 12 in combination with the pull-down transistor 112 on the left-hand side may cooperate to form an electric current path, and the bit line 13, the access transistor 12 in combination with the pull-up transistor 111 on the right-hand side may cooperate to form another electric current path during write operation. In this way, electric current paths are formed on both sides of the conventional 6T SRAM cell to result in higher electric current consumption.

### Summary of the Invention

This in mind, the present invention aims at providing a 6T SRAM cell capable of reducing electricity consumption.

This is achieved by a 6T SRAM cell according to claim 1. The dependent claims pertain to corresponding further developments and improvements.

As will be seen more clearly from the detailed description following below, the 6T SRAM cell includes a write inverter, a read inverter, a write access transistor and a read access transistor. The write inverter includes a write pull-up transistor and a write pull-down transistor which are to be coupled in series between a supply voltage source and a complementary voltage source. The read inverter includes a read pull-up transistor and a read pull-down transistor which are to be coupled in series between the supply voltage source and the complementary voltage source. The read inverter has an output terminal that is connected electrically to an input terminal of the write inverter. The read inverter further has an input terminal that is coupled to an output terminal of the write inverter. The write access transistor is to be coupled electrically between the output terminal of the write inverter and a write bit line. The read access transistor is to be coupled electrically between the output terminal of the read inverter and a read bit line. To-be-written data held by the write bit line is written into the memory cell via the write access transistor in a one-sided write operation, and to-be-read data stored by the memory cell is read by the read bit line via the read access transistor in a one-sided read operation. Equivalent resistance of the read pull-up transistor is smaller than that of the read access transistor, and equivalent resistance of the read pull-down transistor is smaller than that of the read access transistor.

### Brief Description of the Drawings

In the following, the invention is further illustrated by way of example, taking reference to the accompanying drawings thereof:
Figure 1 is a schematic diagram of a conventional 6T SRAM cell;
Figure 2 is a schematic diagram of an embodiment of a memory cell according to the present invention;
Figure 3 is another schematic diagram of the embodiment; and
Figure 4 is further another schematic diagram of the embodiment.

### Detailed Description

Before describing this invention in detail, it should be noted herein that throughout this disclosure, when two elements are described as being "coupled in series," "connected in series" or the like, it is merely intended to portray a serial connection between the two elements without necessarily implying that the currents flowing through the two elements are identical to each other and without limiting whether or not an additional element is coupled to a common node between the two elements. Essentially, "a series connection of elements," "a series coupling of elements" or the like as used throughout this disclosure should be interpreted as being such when looking at those elements alone.

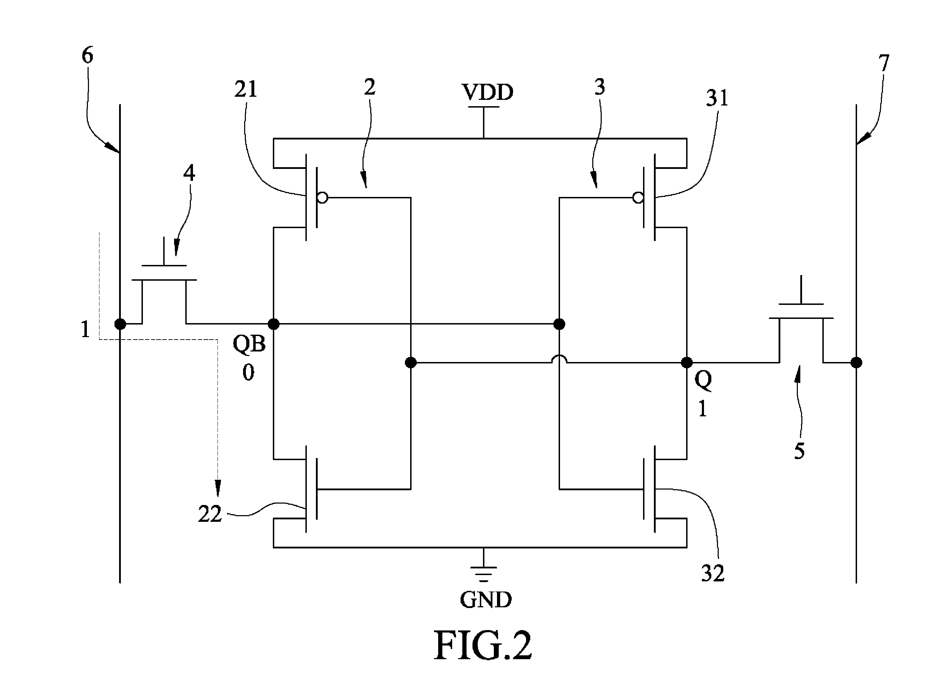

Referring to Figure 2, an embodiment of a memory cell, for example, a 6T SRAM cell, according to the present invention includes a write inverter 2, a read inverter 3, a write access transistor 4 and a read access transistor 5.

The write inverter 2 includes a write pull-up transistor 21 and a write pull-down transistor 22 which are to be coupled in series between a supply voltage source (VDD) and a complementary voltage source (GND). For the convenience of explanation, an output terminal of the write inverter 2 is denoted as (QB).

The read inverter 3 includes a read pull-up transistor 31 and a read pull-down transistor 32 which are to be coupled in series between the supply voltage source (VDD) and the complementary voltage source (GND). The read inverter 3 has an output terminal that is connected electrically to an input terminal of the write inverter 2. For the convenience of explanation, the output terminal of the read inverter 3 is denoted as (Q). The read inverter 3 further has an input terminal that is coupled to the output terminal (QB) of the write inverter 2.

The write access transistor 4 is to be coupled electrically between the output terminal (QB) of the write inverter 2 and a write bit line 6.

The read access transistor 5 is to be coupled electrically between the output terminal (Q) of the read inverter 3 and a read bit line 7.

Specifically, an area of the write pull-up transistor 21 is smaller than an area of the write access transistor 4 (i.e., equivalent resistance of the write pull-up transistor 21 is greater than equivalent resistance of the write access transistor 4). Moreover, an area of the write pull-down transistor 22 is smaller than the area of the write access transistor 4 (i.e., equivalent resistance of the write pull-down transistor 22 is greater than the equivalent resistance of the write access transistor 4).

It is noted that the write pull-up transistor 21 and the write pull-down transistor 22 may be designed to have identical drive abilities. However, the write pull-up transistor 21 and the write pull-down transistor 22 may alternatively have distinct designs according to practical needs, and are not limited to the disclosure herein.

To-be-written data held by the write bit line 6 is written into the memory cell via the write access transistor 4 in a one-sided write operation. To-be-read data stored by the memory cell is read by the read bit line 7 via the read access transistor 5 in a one-sided read operation.

Based on the aforementioned explanation, the embodiment has the following merits.

First, by dividing the memory cell into two sides designated respectively for write and read operations, and by performing one-sided write operation and one-sided read operation, only one path on the side of the write inverter 2 may consume electricity even if a voltage level of to-be-written data is different from a voltage level of data stored by the memory cell. Compared with the conventional technology which may result in electricity consumption on both sides, electricity consumption during write operation may be significantly reduced in this embodiment. Details of the same are explained hereinafter.

Referring to Figure 2, for example, during the write operation, in the case where the output terminal (QB) of the write inverter 2 is at a low voltage level and the output terminal (Q) of the read inverter 3 is at a high voltage level, if data held by the write bit line 6 is at a high voltage level, since one-sided write operation is performed in this embodiment, after the write access transistor 4 has been turned on and before transitions of the write inverter 2 and the read inverter 3 are completed, only the write access transistor 4 is turned on (the read access transistor 5 is turned off). In this way, compared with the conventional technology in which electric current paths are formed at both sides of the conventional memory cell, only the write bit line 6, the write access transistor 4 in combination with the write pull-down transistor 22 may cooperate to form an electric current path, so as to significantly reduce electricity consumption during write operation.

Second, by designing the area of the write pull-up transistor 21 and the area of the write pull-down transistor 22 to both be smaller than the area of the write access transistor 4, the equivalent resistance of the write pull-up transistor 21 and the write pull-down transistor 22 may both be greater than the equivalent resistance of the write access transistor 4. In this way, a favorable transition effect may be achieved during the write operation, so as to prevent write failure. Details of the same are explained hereinafter.

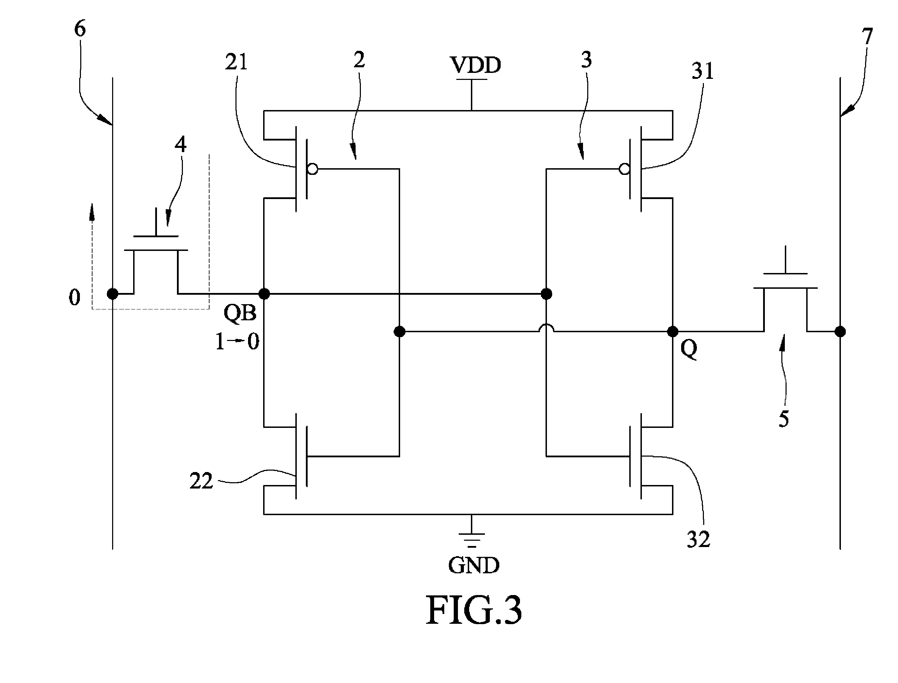

Referring to Figure 3, during the write operation, in the case where the output terminal (QB) is at a high voltage level and the data held by the write bit line 6 is at a low voltage level, i.e., data at the output terminal (QB) is to be changed from 1 to 0 as shown in this figure, the write pull-up transistor 21 and the write access transistor 4 are conducting after the write access transistor 4 has been turned on, and a voltage at the output terminal (QB) is determined based on divided voltages between the equivalent resistance of the write pull-up transistor 21 and the write access transistor 4. Therefore, the greater the equivalent resistance of the write pull-up transistor 21 is than the equivalent resistance of the write access transistor 4, the closer the voltage at the output terminal (QB) is to a low voltage level. Hence, a favorable write ability may be obtained.

Similarly, in the case where the output terminal (QB) is at a low voltage level and the data held by the write bit line 6 is at a high voltage level, i.e., data at the output terminal QB is to be changed from 0 to 1, , the write pull-down transistor 22 and the write access transistor 4 are conducting after the write access transistor 4 has been turned on, and a voltage at the output terminal (QB) is determined based on divided voltages between the equivalent resistance of the write pull-down transistor 22 and the write access transistor 4. Therefore, the greater the equivalent resistance of the write pull-down transistor 22 is than the equivalent resistance of the write access transistor 4, the closer the voltage at the output terminal (QB) is to a high voltage level. Hence, a favorable write ability may be obtained.

Third, by designing at least one of the area of the read pull-up transistor 31 and the area of the read pull-down transistor 32 to be greater than that of the read access transistor 5, the equivalent resistance of said at least one of the read pull-up transistor 31 and the read pull-down transistor 32 may be smaller than that of the read access transistor 5. In this way, a favorable transition effect may be achieved during the read operation, so as to prevent read failure. Details of the same are explained hereinafter.

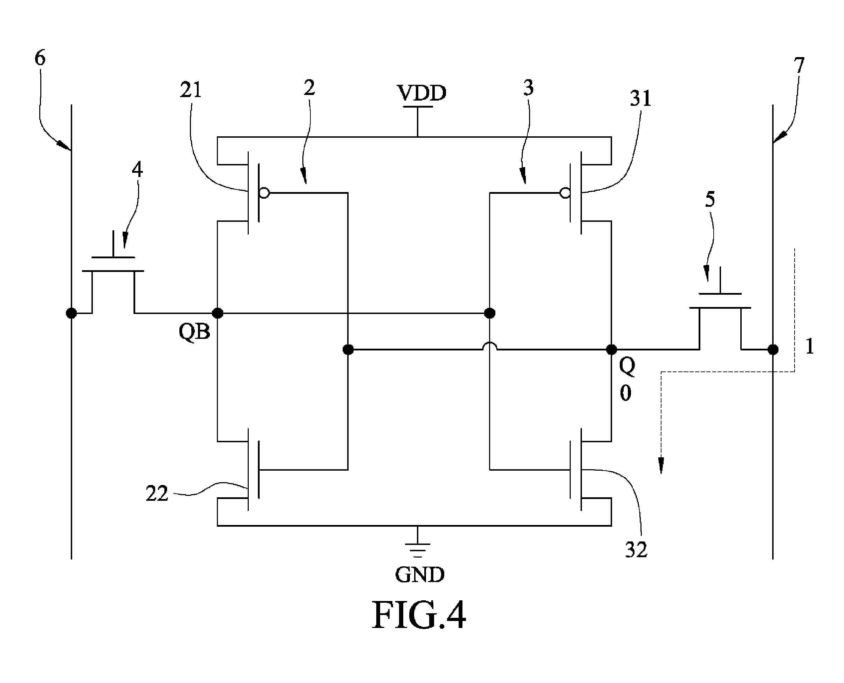

Referring to Figure 4, during the read operation, in the case where the output terminal Q is at a low voltage level and the read bit line 7 is precharged to a high voltage level, the read pull-down transistor 32 and the read access transistor 5 are conducting, and a voltage at the output terminal (Q) is determined based on divided voltages between the equivalent resistance of the read pull-down transistor 32 and the read access transistor 5. Therefore, the smaller the equivalent resistance of the read pull-down transistor 32 is than the equivalent resistance of the read access transistor 5, the closer the voltage at the output terminal (Q) is to a low voltage level. That is to say, the voltage at the output terminal (Q) may be less vulnerable to influence of the voltage level to which the read bit line 7 is precharged. In this way, not only may the degree to which the to-be-read data stored at the output terminal (Q) is influenced be reduced, but a chance that the write pull-down transistor 22 is turned on inversely due to noise may also be reduced, so as to alleviate an issue that stored data may be flipped.

Similarly, in the case where the output terminal (Q) is at a high voltage level and the read bit line 7 is precharged to a low voltage level, the read pull-up transistor 31 and the read access transistor 5 are conducting, so that a voltage at the output terminal (Q) is determined based on divided voltages between the equivalent resistance of the read pull-up transistor 31 and the read access transistor 5. Therefore, the smaller the equivalent resistance of the read pull-up transistor 31 is than the equivalent resistance of the read access transistor 5, the closer the voltage at the output terminal (Q) is to a high voltage level. In this way, the degree to which the to-be-read data stored at the output terminal (Q) is influenced may be reduced, and the issue of the flip of stored data may be alleviated.

It should be noted that when this embodiment is applied to an architecture disclosed in "Semiconductor memory without sense amplifier", Taiwanese Patent Number I452575 by the same applicant, since a sense amplifier is not required in the architecture, a scenario of precharging may be omitted. In this way, each of the read pull-up transistor 31 and the read pull-down transistor 32 should be designed to have an area greater than the area of the read access transistor 5 (i.e., the equivalent resistance of each of the read pull-up transistor 31 and the read pull-down transistor 32 is smaller than the equivalent resistance of the read access transistor 5). Therefore, regardless of whether the read bit line 7 is at the high voltage level or at the low voltage level, the aforementioned merits may be achieved.

Specifically, a channel width-to-length ratio of the read pull-up transistor 31 is greater than that of the read access transistor 5, and a channel width-to-length ratio of the read pull-down transistor 32 is greater than that of the read access transistor 5. Moreover, a channel width of the read pull-up transistor 31 is greater than that of the read access transistor 5, and a channel width of the read pull-down transistor 32 is greater than that of the read access transistor 5.

Specifically, a channel width-to-length ratio of the write pull-up transistor 21 is smaller than that of the write access transistor 4, and a channel width-to-length ratio of the write pull-down transistor 22 is smaller than that of the write access transistor 4. Moreover, a channel width of the write pull-up transistor 21 is smaller than that of the write access transistor 4, and a channel width of the write pull-down transistor 22 is smaller than that of the write access transistor 4.

Specifically, a threshold voltage (Vₜₕ) of the read pull-up transistor 31 is smaller than that of the read access transistor 5, and a threshold voltage of the read pull-down transistor 32 is smaller than that of the read access transistor 5. Further, a threshold voltage of the write pull-up transistor 21 is greater than that of the write access transistor 4, and a threshold voltage of the write pull-down transistor 22 is greater than that of the write access transistor 4. It is noted that since the threshold voltage of the read access transistor 5 is substantially equal to that of the write access transistor 4, a threshold voltage of the write inverter 2 is greater than that of the read inverter 3.

To sum up, by the specific designs of the transistors mentioned above, the object of the present invention may be achieved.

## Claims

1. A 6T SRAM (six-transistor static random-access memory) cell comprising:
a write inverter (2) including a write pull-up transistor (21) and a write pull-down transistor (22) which are to be coupled in series between a supply voltage source and a complementary voltage source;
a read inverter (3) including a read pull-up transistor (31) and a read pull-down transistor (32) which are to be coupled in series between the supply voltage source and the complementary voltage source, said read inverter (3) having an output terminal that is connected electrically to an input terminal of said write inverter (2), said read inverter (3) further having an input terminal that is coupled to an output terminal of said write inverter (2);
a write access transistor (4) to be coupled electrically between the output terminal of said write inverter (2) and a write bit line (6); and
a read access transistor (5) to be coupled electrically between the output terminal of said read inverter (3) and a read bit line (7);
**characterized by**:
wherein to-be-written data held by the write bit line (6) is written into said 6T SRAM cell via said write access transistor (4) in a one-sided write operation, and to-be-read data stored by said 6T SRAM cell is read by the read bit line (7) via said read access transistor in a one-sided read operation;
wherein equivalent resistance of said read pull-up transistor (31) is smaller than that of said read access transistor (5), and equivalent resistance of said read pull-down transistor (32) is smaller than that of said read access transistor (5).

2. The 6T SRAM cell of Claim 1, **characterized in that** an area of said read pull-up transistor (31) is greater than that of said read access transistor (5), and an area of said read pull-down transistor (32) is greater than that of said read access transistor (5).

3. The 6T SRAM cell of Claim 1, **characterized in that** a channel width-to-length ratio of said read pull-up transistor (31) is greater than that of said read access transistor (5), and a channel width-to-length ratio of said read pull-down transistor (32) is greater than that of said read access transistor (5).

4. The 6T SRAM cell of Claim 1, **characterized in that** a channel width of said read pull-up transistor (31) is greater than that of said read access transistor (5), and a channel width of said read pull-down transistor (32) is greater than that of said read access transistor (5).

5. The 6T SRAM cell of Claim 1, **characterized in that** a threshold voltage of said read pull-up transistor (31) is smaller than that of said read access transistor (5), and a threshold voltage of said read pull-down transistor (32) is smaller than that of said read access transistor (5).

6. The 6T SRAM cell of Claim 1, **characterized in that** equivalent resistance of said write pull-up transistor (21) is greater than that of said write access transistor (4), and equivalent resistance of said write pull-down transistor (22) is greater than that of said write access transistor (4).

7. The 6T SRAM cell of Claim 6, **characterized in that** an area of said write pull-up transistor (21) is smaller than that of said write access transistor (4), and an area of said write pull-down transistor (22) is smaller than that of said write access transistor (4).

8. The 6T SRAM cell of Claim 6, **characterized in that** a channel width-to-length ratio of said write pull-up transistor (21) is smaller than that of said write access transistor (4), and a channel width-to-length ratio of said write pull-down transistor (22) is smaller than that of said write access transistor (4).

9. The 6T SRAM cell of Claim 6, **characterized in that** a channel width of said write pull-up transistor (21) is smaller than that of said write access transistor (4), and a channel width of said write pull-down transistor (22) is smaller than that of said write access transistor (4).

10. The 6T SRAM cell of Claim 6, **characterized in that** a threshold voltage of said write pull-up transistor (21) is greater than that of said write access transistor (4), and a threshold voltage of said write pull-down transistor (22) is greater than that of said write access transistor (4).
